# EUROPEAN PATENT APPLICATION

(11) **EP 3 490 061 A1**
(43) Date of publication of application: **29.05.2019**
(21) Application number: 18207924.4
(22) Date of filing: 23.11.2018
(51) Int. Cl.: H01Q 1/32, G01S 13/93, H01Q 15/08, H01Q 19/06, H01Q 21/08

(54) **ANTENNA DEVICE**

(30) Priority: 27.11.2017 JP 2017226983
(71) Applicant: Panasonic Intellectual Property Management Co., Ltd., Osaka-shi, Osaka 540-6207 (JP)
(72) Inventor: SHIOZAKI, Ryosuke, Osaka-shi, Osaka 540-6207 (JP); YUI, Tomohiro, Osaka-shi, Osaka 540-6207 (JP); SUZUKI, Kouji, Osaka-shi, Osaka 540-6207 (JP); SAITO, Noriaki, Osaka-shi, Osaka 540-6207 (JP); KASHINO, Yuichi, Osaka-shi, Osaka 540-6207 (JP); TAKAHASHI, Ken, Osaka-shi, Osaka 540-6207 (JP)
(74) Representative: Grünecker Patent- und Rechtsanwälte PartG mbB

(57) **Abstract**

An antenna device that includes a housing formed with an window surface and transmits and receives an electromagnetic wave through a cover member facing the window surface, comprises: a transmitting antenna that is provided inside the housing and transmits the electromagnetic wave to a side of the cover member; a receiving antenna that receives the electromagnetic wave; a circuit board that extends along a transmission direction of the electromagnetic wave and includes a board surface provided with the transmitting antenna and the receiving antenna; and a dielectric lens covering the window surface that narrows a beam of the electromagnetic wave transmitted from the transmitting antenna to transmit the beam outside the housing and collects the electromagnetic wave from outside the housing to transmit the electromagnetic wave to the receiving antenna.

## Description

### BACKGROUND

### 1. Technical Field

The present disclosure relates to an antenna device.

### 2. Description of the Related Art

An antenna device has been known, which is for a radar using electromagnetic waves in a frequency band of millimeter-waves and microwaves to detect a position of an object (hereinafter also referred to as "target") without contact.

The antenna device is, for example, mounted in a vehicle and used for monitoring multiple directions including a front direction, front-side directions, and rear-side directions. In terms of protecting a vehicle device from a flying object outside the vehicle device and keeping the exterior of the vehicle body, such an antenna device is mounted inside of a cover member of a vehicle such as a bumper and is configured to transmit and receive electromagnetic waves through that cover member.

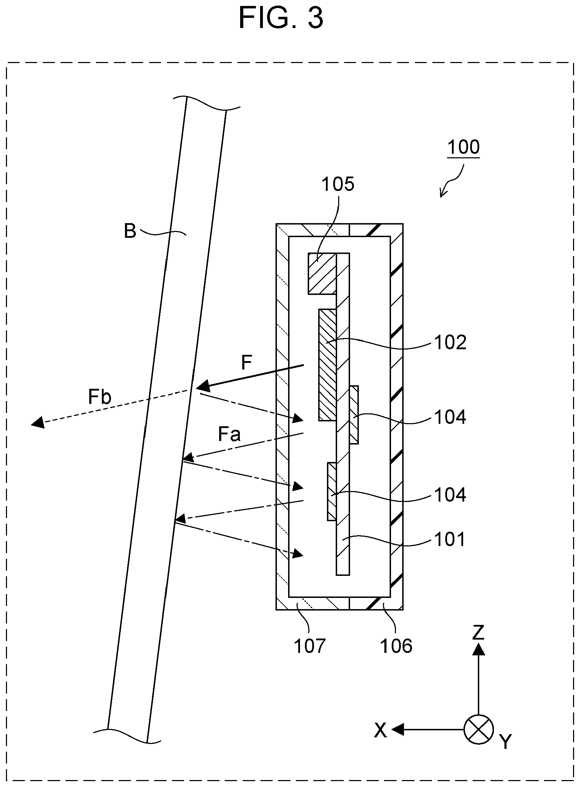

Electromagnetic waves with a high frequency such as the millimeter-waves generally have a property of passing through an insulator (e.g., resin material forming bumper); however, transmission of that electromagnetic waves varies depending on conditions such as a permittivity of the insulator, a thickness of the insulator, and an incident angle on the insulator. Thus, a part of the electromagnetic waves transmitted by the antenna device is reflected by an inner wall of the cover member, and this causes noise when that antenna device is detecting an object. In particular, those reflected waves from that cover member may cause multiple reflection between the cover member and a board on which an antenna of the antenna device is disposed (described later with reference to Fig. 3).

Japanese Patent Application Publication No. 2009-103457 discloses that, for example, the multiple reflection between the cover member and the antenna surface facing the cover member is inhibited by inclining the antenna surface so as to deviate from the antenna surface propagation directions of the reflected waves from the cover member.

### SUMMARY

However, since the conventional technique according to Japanese Unexamined Patent Application Publication No. 2009-103457 presupposes that the antenna surface on the board is disposed to face the cover member, it is impossible to avoid the reflected waves from the cover member arriving at the antenna surface depending on the shape of that cover member, and accuracy of object detection thus can be insufficient. In addition, since in the conventional technique according to Japanese Unexamined Patent Application Publication No. 2009-103457, directions of the transmitted electromagnetic waves are restricted by the shape of the cover member, it is impossible to efficiently transmit the electromagnetic waves to desirable directions.

On the other hand, in a general antenna device, output gain sometimes decreases because the multiple reflection between the antenna device and the cover (bumper) member causes phases to cancel out each other.

One non-limiting and exemplary embodiment is in light of the above problems and provides an antenna device that is preferable for transmitting and receiving electromagnetic waves through a cover member.

In one general aspect, the techniques disclosed here feature an antenna device that includes a housing formed with an window surface and transmits and receives an electromagnetic wave through a cover member facing the window surface, comprising: a transmitting antenna that is provided inside the housing and transmits the electromagnetic wave to a side of the cover member; a receiving antenna that receives the electromagnetic wave; a circuit board that extends along a transmission direction of the electromagnetic wave and includes a board surface provided with the transmitting antenna and the receiving antenna; and a dielectric lens covering the window surface that narrows a beam of the electromagnetic wave transmitted from the transmitting antenna to transmit the beam outside the housing and collects the electromagnetic wave from outside the housing to transmit the electromagnetic wave to the receiving antenna.

It should be noted that general or specific embodiments may be implemented as a system, a method, an integrated circuit, a computer program, a storage medium, or any selective combination thereof.

An antenna device according to the present disclosure is more preferable to be used for transmitting and receiving electromagnetic waves through a cover member.

Additional benefits and advantages of the disclosed embodiments will become apparent from the specification and drawings. The benefits and/or advantages may be individually obtained by the various embodiments and features of the specification and drawings, which need not all be provided in order to obtain one or more of such benefits and/or advantages.

### BRIEF DESCRIPTION OF THE DRAWINGS

Fig. 1 is a diagram that illustrates an example of a state where an antenna device according to a conventional technique is mounted in a cover member of a vehicle;
Fig. 2 is a side cross-sectional view that illustrates an example of a configuration of the antenna device according to the conventional technique;
Fig. 3 is a diagram that illustrates behavior of an electromagnetic wave in the antenna device according to the conventional technique;
Fig. 4 is a side cross-sectional view that illustrates an example of a configuration of an antenna device according to a first embodiment;
Fig. 5 is a plan view that illustrates an example of a configuration of the antenna device according to the first embodiment;
Fig. 6A is a diagram that illustrates behavior of an electromagnetic wave in the antenna device according to the first embodiment;
Fig. 6B is a diagram that illustrates behavior of an electromagnetic wave in the antenna device according to the first embodiment;
Fig. 7 is a graph that illustrates a result of a simulation of verifying a radar performance of the antenna device according to the first embodiment;
Fig. 8 is a side cross-sectional view that illustrates an example of a configuration of an antenna device according to a second embodiment;
Fig. 9 is a side cross-sectional view that illustrates an example of a configuration of an antenna device according to a third embodiment;
Fig. 10 is a side cross-sectional view that illustrates an example of a configuration of an antenna device according to a fourth embodiment;
Fig. 11 is a side cross-sectional view that illustrates an example of a configuration of an antenna device according to a fifth embodiment;
Fig. 12 is a plan view that illustrates an example of a configuration of the antenna device according to the fifth embodiment;
Fig. 13 is a side cross-sectional view that illustrates an example of a configuration of an antenna device according to a sixth embodiment;
Fig. 14 is a plan view that illustrates an example of a configuration of an antenna device according to a seventh embodiment; and
Fig. 15 is a diagram that illustrates an example of an antenna device according to an eighth embodiment.

### DETAILED DESCRIPTION

Embodiments of the present disclosure are described below with reference to accompanied drawings. In this description and the drawings, duplicated descriptions of constituents having substantially the same functions are omitted by denoting the same reference signs.

In order to clarify positional relationships between the constituents, a common Cartesian coordinate system (X, Y, Z) based on a front direction in which an antenna device transmits electromagnetic waves to outside the device (i.e., a direction as a target of object detection) is indicated throughout the drawings. Hereinafter, descriptions are given using an X-axis positive direction representing the front direction in which the antenna device transmits the electromagnetic waves to outside the device (hereinafter abbreviated as "front direction"), a Y-axis positive direction representing a right side surface direction of the antenna device, and a Z-axis positive direction representing an upward direction of the antenna device (hereinafter abbreviated as "upward direction").

### (Underlying Knowledge Forming Basis of the Present Disclosure)

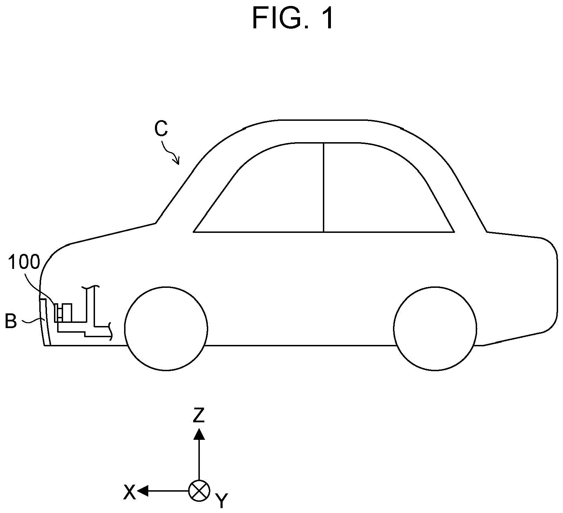

First, an effect of the electromagnetic waves reflected by a cover member on a detection performance of the antenna device is described with reference to Figs. 1 to 3. Hereinafter, as an application target of the antenna device of the present disclosure, a vehicle-mounted radar device is described as an example.

Fig. 1 is a diagram that illustrates an example of a state where an antenna device 100 according to a conventional technique is mounted in a cover member B of a vehicle C (here, a bumper member of the vehicle C). In Fig. 1, the Z-axis positive direction corresponds to an upward direction of the vehicle C (direction perpendicular to ground) while the X-axis positive direction corresponds to a traveling direction of the vehicle C (direction horizontal to ground).

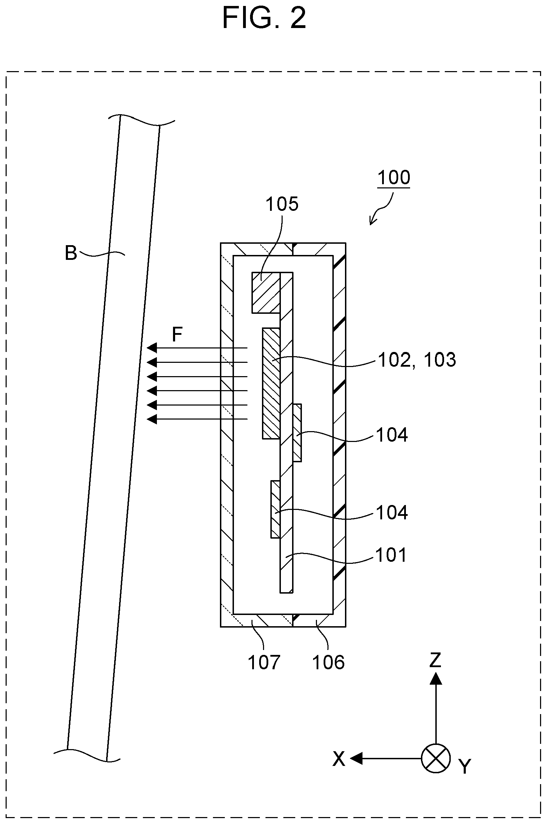

Fig. 2 is a side cross-sectional view that illustrates an example of a configuration of the antenna device 100 according to the conventional technique.

The antenna device 100 according to the conventional technique includes, for example, a circuit board 101, a transmitting antenna 102, a receiving antenna 103, signal processing ICs 104, a connector 105, a housing 106, and a radome 107.

A board surface of the circuit board 101 is mounted with the transmitting antenna 102, the receiving antenna 103, the signal processing ICs 104, and the connector 105.

In general, a patch antenna and the like that transmits and receives electromagnetic waves in a normal direction of the board surface of the circuit board 101 is used as the transmitting antenna 102 and the receiving antenna 103.

The circuit board 101 is disposed such that the board surface on which the transmitting antenna 102 and receiving antenna 103 are disposed is directed toward the front direction side of the vehicle C so that the board surface faces the cover member B. In this way, directivity directions of the transmitting antenna 102 and receiving antenna 103 is directed toward the front direction side of the antenna device 100. Solid arrows F in Fig. 2 represent the electromagnetic waves transmitted by the transmitting antenna 102.

The circuit board 101 is stored in the housing 106, and the transmitting antenna 102 and receiving antenna 103 respectively transmits and receives the electromagnetic waves to and from outside the device through the radome 107 supported at a front surface of the housing 106.

With such a configuration, the antenna device 100 according to the conventional technique transmits and receives the electromagnetic waves through the cover member B (e.g., bumper member) to specify a position of a target outside the device. As illustrated in Fig. 2, the bumper member of the vehicle C usually has a shape extending in a direction vertical to the ground.

Fig. 3 is a diagram that illustrates behavior of the electromagnetic wave in the antenna device 100 according to the conventional technique. Fig. 3 illustrates an aspect where the antenna device 100 transmits and receives the electromagnetic wave in a direction horizontal to the ground to allow the electromagnetic wave to pass through the cover member B.

The solid arrow F in Fig. 3 represents the electromagnetic wave transmitted by the transmitting antenna 102. Dashed-dotted line arrows Fa represent a part of the electromagnetic wave transmitted by the transmitting antenna 102 that is a reflected wave reflected by the cover member B. A dotted line arrow Fb represents rest part of the electromagnetic wave transmitted by the transmitting antenna 102 that is an electromagnetic wave passing through the cover member B. For the purpose of illustration, a reflection at the radome 107 is ignored herein.

First, when the electromagnetic wave is transmitted from the transmitting antenna 102, that electromagnetic wave passes through the radome 107 and then arrives at the cover member B. Most part of the electromagnetic wave arriving at the cover member B passes through the cover member B and is transmitted toward the target outside the vehicle, but a part of the electromagnetic wave is reflected by the surface of the cover member B and returns back to the circuit board 101 by passing through the radome 107 again.

The electromagnetic wave that is back to the circuit board 101 is reflected by the circuit board 101 again and travels toward the cover member B side by passing through the radome 107. That electromagnetic wave repeats reflection between the cover member B and the board surface of the circuit board 101, and a part of that electromagnetic wave then arrives at the receiving antenna 103 (also referred to as "multiple reflection").

In this way, since the multiply reflected electromagnetic wave has a phase different from the reflected wave from the target, the multiply reflected electromagnetic wave and the reflected wave from the target affect their intensity each other depending on an angle of the reflected wave arriving at the receiving antenna 103. As a result, that multiply reflected electromagnetic wave locally has an angle that causes the receiving antenna 103 to be impossible to detect the reflected wave from the target (or an angle that decreases sensitivity of the detection). In addition, since that multiply reflected electromagnetic wave has a phase different from the reflected wave from the target when arriving at the receiving antenna 103, that multiply reflected electromagnetic wave also makes an error when estimating an azimuth of that target.

Another part of the electromagnetic wave reflected by the surface of the cover member B repeats reflections between the cover member B and other parts of the vehicle and returns back to the receiving antenna 103 through a complicated propagation route (not illustrated; also referred to as "diffracted wave"). Although this diffracted wave enters the receiving antenna 103 with some extent of delay, it is still difficult in signal processing to distinguish that diffracted wave and the reflected wave from the target. There is thus a risk that the diffracted wave may cause detection of an object that does not actually exist.

### (First Embodiment)

### [Configuration of Antenna Device]

In relation to reduction of effects of the above-described multiple reflection and diffracted wave, an embodiment of the present disclosure is described below.

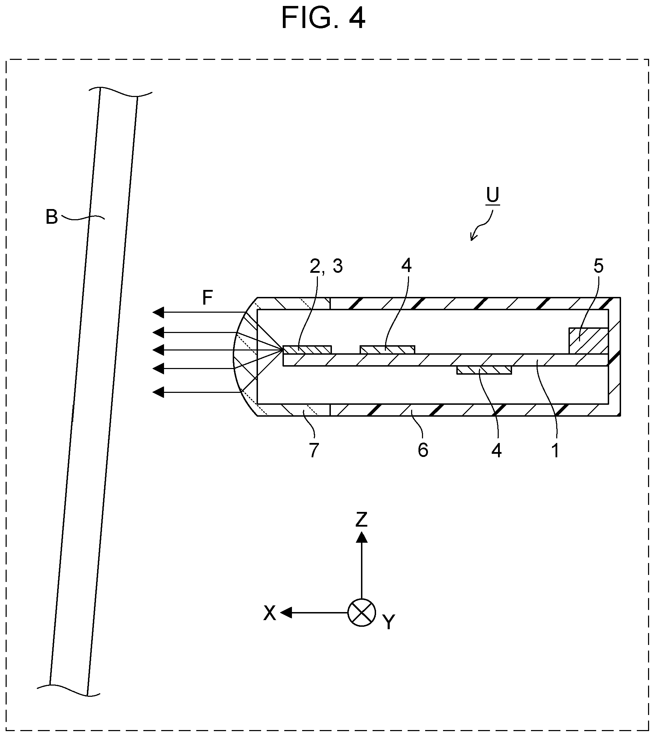

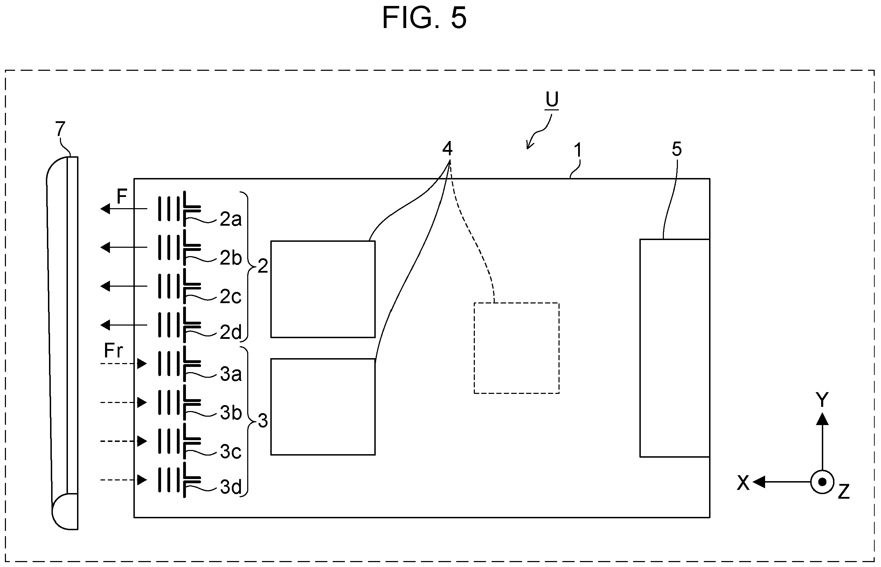

Fig. 4 is a side cross-sectional view that illustrates an example of a configuration of an antenna device U according to this embodiment. Fig. 5 is a plan view that illustrates an example of a configuration of the antenna device U according to this embodiment.

The solid arrows F in the Figs. 4 and 5 represent the electromagnetic waves transmitted by the transmitting antenna. Dotted line arrows Fr represent the reflected waves from the target. In Figs. 4 and 5, illustration of a structure supporting the antenna device U in the vehicle C is omitted. In Fig. 5, illustration of the housing 6 is omitted.

For example, likewise the antenna device 100 according to the conventional technique, the antenna device U according to this embodiment is applied to a radar device and is disposed in the cover member B (here, bumper member B) of the vehicle C to transmit and receive the electromagnetic waves through the cover member B (see Fig. 1).

The antenna device U according to this embodiment includes a circuit board 1, a transmitting antenna 2, a receiving antenna 3, signal processing ICs 4, a connector 5, a housing 6, and a dielectric lens 7.

The antenna device U according to this embodiment uses the transmitting antenna 2 and the receiving antenna 3 disposed on a front region of the circuit board 1 to transmit and receive the electromagnetic waves to and from outside the device through the dielectric lens 7 in a directivity direction that is the front side substantially parallel to the board surface of the circuit board 1. That is, the antenna device U according to this embodiment has a configuration in which the circuit board 1 is disposed such that an extending direction of the board surface intersects with an extending direction of the cover member B (e.g., at right angles).

With such a configuration, the antenna device U according to this embodiment inhibits the reflected wave reflected by the cover member B from multiply reflecting between the cover member B and the circuit board 1 and the like and causing interference with the reflected wave from the target, and inhibits that reflected wave from being the diffracted wave and entering the receiving antenna 3.

The circuit board 1 is a board mounted with the transmitting antenna 2, the receiving antenna 3, the signal processing ICs 4, and the connector 5. A board surface of a front surface side or back surface side of the circuit board 1 is mounted with the transmitting antenna 2, the receiving antenna 3, the signal processing ICs 4, the connector 5, and so on while (not-illustrated) wiring for electrically connecting these mounted parts (the transmitting antenna 2, the receiving antenna 3, the signal processing ICs 4, the connector 5, and so on) are patterned.

The circuit board 1 is disposed such that the extending direction of the board surface is parallel to the front-rear direction. In other words, the circuit board 1 is disposed such that the extending direction of the board surface intersects with the extending direction (here, substantially Z-axis direction) of the cover member B.

Material of the circuit board 1 is not specifically limited in the present disclosure; however, it is possible to use a printed circuit board (PCB), for example. Also, a multi-layer board and a semi-conductor board mounted with the signal processing ICs 4 may also be used as the circuit board 1. The circuit board 1 is, for example, in a flat plate shape.

The transmitting antenna 2 is disposed on the front region of the circuit board 1 and transmits the electromagnetic waves toward a direction of a front end side of the circuit board 1 in parallel to the board surface of the circuit board 1. The receiving antenna 3 is disposed on the front region of the circuit board 1 and receives the reflected waves from the direction of the front end side of the circuit board 1 in parallel to the board surface of the circuit board 1. In other words, the transmitting antenna 2 and the receiving antenna 3 have directivity characteristics of transmitting and receiving in the direction of the front end side of the circuit board 1.

Typically, an end-fire array antenna having the directivity characteristics in the direction of the front end side of the circuit board 1 is applied as the transmitting antenna 2 and the receiving antenna 3. The end-fire array antenna includes multiple strip conductors arranged such that their longitudinal directions are parallel to each other and transmits and receives the electromagnetic waves along the directions in which these multiple strip conductors are arranged.

The transmitting antenna 2 and the receiving antenna 3 may at least be composed of an antenna having a conductor pattern formed on the circuit board 1, and a Yagi array antenna, Fermi antenna, post-wall waveguide antenna, post-wall horn antenna, or the like can be applied instead of the end-fire array antenna. The transmitting antenna 2 and the receiving antenna 3 may be composed of a single antenna shared for transmitting and receiving the electromagnetic waves.

Multiple antenna elements of the transmitting antenna 2 and receiving antenna 3 are respectively disposed on the front region in the board surface of the circuit board 1 along the Y direction (in Fig. 5, 2a, 2b, 2c, and 2d represent the antenna elements of the transmitting antenna 2 while 3a, 3b, 3c, and 3d represent the antenna elements of the receiving antenna 3). For example, Fig. 5 illustrates an aspect where the transmitting antenna 2 is disposed on a region on the Y-axis positive direction side of the front region in the board surface of the circuit board 1 while the receiving antenna 3 is disposed on a region on a Y-axis negative direction side of the front region in the board surface of the circuit board 1.

The electromagnetic waves transmitted by the transmitting antenna 2 are converted to plane waves by the dielectric lens 7 and transmitted to the front side of outside the antenna device U (here, in substantially horizontal direction). The returning reflected waves that are a part of the electromagnetic waves transmitted by the transmitting antenna 2 and reflected by the target outside device are collected into the dielectric lens 7 and transmitted to the receiving antenna 3. The transmitting antenna 2 and the receiving antenna 3 are respectively connected with the signal processing ICs 4 through wiring formed on the circuit board 1.

Each signal processing IC 4 (corresponding to a signal processing unit of the present invention) transmits a driving signal with a high frequency (e.g., millimeter-wave frequency band) to the transmitting antenna 2 to allow the transmitting antenna 2 to transmit the electromagnetic waves (e.g., electromagnetic waves from a pulse compression method with pulse sequences or electromagnetic waves as sequential waves with modulated frequency).

The signal processing IC 4 receives a reflected wave signal from the receiving antenna 3 and applies object detection processing (e.g., detection processing and frequency analysis processing) to that reflected wave signal to detect a distance to the target (e.g., vehicle or person), an azimuth where the target exists, and additionally a reflection strength and speed of the target. For example, the signal processing IC 4 uses a method of scanning the transmission direction of the electromagnetic waves transmitted from the transmitting antenna 2 or detecting a received phase difference of the reflected wave signals respectively received by radiation elements of the receiving antenna 3 arranged as an array to estimate the azimuth of the target.

The processing performed by the signal processing IC 4 is similar to a known configuration; thus, a detailed description thereof is omitted herein.

For example, the signal processing IC 4 is composed mainly of a known microcomputer including a CPU, a ROM, a RAM, and so on, and is additionally composed of a driving circuit that generates a high-frequency driving signal transmitted to the transmitting antenna 2 and a detection circuit for processing of receiving the reflected wave signal from the receiving antenna 3. However, it is needless to say that a part of the signal processing IC 4 can be implemented only with a dedicated hardware having no CPU or the like.

In Fig. 5, as an example of the signal processing ICs 4, signal processing ICs that perform signal processing related to millimeter-wave bands for the transmitting antenna 2 and receiving antenna 3, and a signal processing IC that performs signal processing related to a baseband band are illustrated as individual chips. Note that a part of the processing of the signal processing ICs 4 may be executed by an external equipment such as a vehicle ECU.

Each signal processing IC 4 may be mounted on the board surface of the circuit board 1 integrally with the transmitting antenna 2 or the receiving antenna 3. This makes it possible to further reduce the distance of a wiring portion between the transmitting antenna 2 or the receiving antenna 3 and the signal processing IC 4.

The connector 5 communicably connects the signal processing ICs 4 and the external equipment (e.g., vehicle ECU mounted in vehicle C).

The housing 6 houses the circuit board 1 while supporting the dielectric lens 7 frontward of the circuit board 1. The housing 6 typically houses the circuit board 1 in a substantially sealed state.

An outer shape of the housing 6 is, in terms of miniaturization, a shape following an outer shape of the circuit board 1 (e.g., a rectangular shape in which a storage space having a substantially flat plate shape is formed) having a length in the Z direction shorter than a length in the X direction, for example. The length in the Z direction of the housing 6 is, for example, set as a length that is the sum of an aperture length and a predetermined margin width that can obtain desirable gain when transmitting and receiving the electromagnetic waves.

On a front surface of the housing 6, a window for transmitting and receiving the electromagnetic waves to and from the transmitting antenna 2 and the receiving antenna 3 is formed. This window is an window surface of the housing 6. This window is provided with the dielectric lens 7.

A wall region of walls of the housing 6 that does not allow the electromagnetic waves to pass therethrough (i.e., region other than window), for example, extends frontward of positions where the transmitting antenna 2 and the receiving antenna 3 are disposed. This makes it possible to further inhibit the reflected waves from the cover member B from entering the housing 6.

In terms of preventing the reflected waves from the cover member B from entering the housing 6, improving characteristics of heat release from the circuit board 1, improving EMC characteristics, and the like, a metal member (e.g., aluminum material) is used as material of the housing 6, for example. However, when considering more about cost and weight saving, resin may be used as the material of the housing 6, or the housing 6 and the dielectric lens 7 may be integrally formed of the same resin material. Note that the material of the housing 6 is preferably material with higher thermal conductivity than the dielectric lens 7.

The dielectric lens 7 is supported frontward of the circuit board 1 and narrows a beam of the electromagnetic waves from the transmitting antenna 2 to transmit it to a front region outside the antenna device U. The dielectric lens 7 then collects the reflected waves, which are the transmitted electromagnetic waves returning back from the target, and transmits them to the receiving antenna 3. In other words, the transmitting antenna 2 and the receiving antenna 3 are disposed on a position as a focal point of the dielectric lens 7. For example, the dielectric lens 7 narrows the beam of the electromagnetic waves to such a degree that the electromagnetic waves transmitted by the transmitting antenna 2 are converted to the plane waves.

The dielectric lens 7 increases gain of the transmission and reception of the electromagnetic waves by the transmitting antenna 2 and the receiving antenna 3 and also inhibits the reflected waves from the cover member B from entering the receiving antenna 3 (detail is described later). The dielectric lens 7 also functions as a radome that protects the transmitting antenna 2 and the receiving antenna 3.

Typically, a one-side convex lens on which a front surface (in the X-axis positive direction) is formed in a convex shape can be applied as the dielectric lens 7. Note that a two-sides convex lens, a ball lens, a Fresnel lens, or a combination of these, and a combination of a concave lens and these may also be applied as the dielectric lens 7. In addition, a back surface side of the dielectric lens 7 may be convex in an X-axis negative direction.

Material of the dielectric lens 7 may be arbitrary, and, for example, acrylic resin, tetrafluoroethylene resin, polystyrene resin, polycarbonate resin, polybutylene terephthalate resin, polyphenylene resin, polypropylene resin, syndiotactic polystyrene resin, ABS resin, or the like is used as the material.

A shape of the dielectric lens 7 according to this embodiment is a convex shape only in the X-axis positive direction so as to not narrow the beam of the electromagnetic waves in the Y direction (see Fig. 5). In other words, a shape of a cross-section of a side surface of the dielectric lens 7 in the Y direction has substantially the same shape in any positions. This prevents deterioration of object detection accuracy, which is caused by the electromagnetic waves respectively transmitted from the multiple antenna elements of the transmitting antenna 2 disposed along the Y direction that are oriented in different directions from each other when arriving at the receiving antenna 3 (e.g., accuracy deterioration due to mutual interference or accuracy deterioration due to variation of phase difference).

Meanwhile, to enable identification of the electromagnetic waves respectively transmitted from the multiple antenna elements of the transmitting antenna 2, it is possible to allow the multiple antenna elements of the transmitting antenna 2 to respectively operate in time-sharing or to make polarization directions of the electromagnetic waves respectively transmitted from the multiple antenna elements of the transmitting antenna 2 different from each other. [Behavior of Electromagnetic Wave When Antenna Device is in Operation]

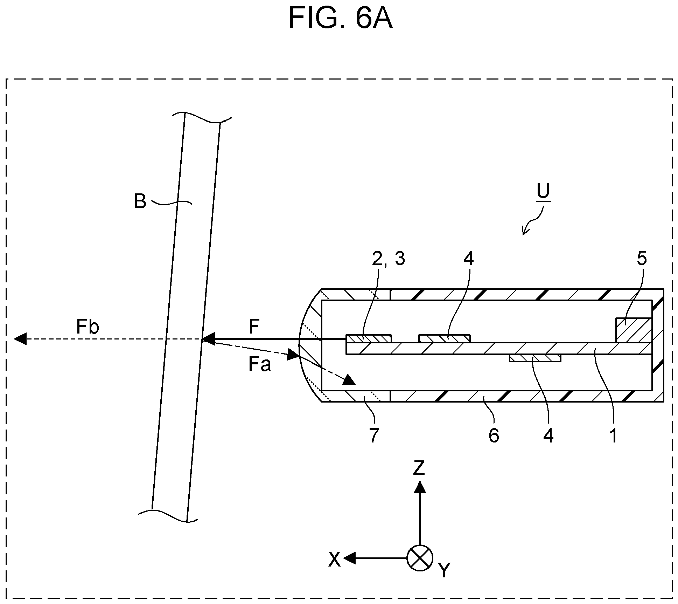

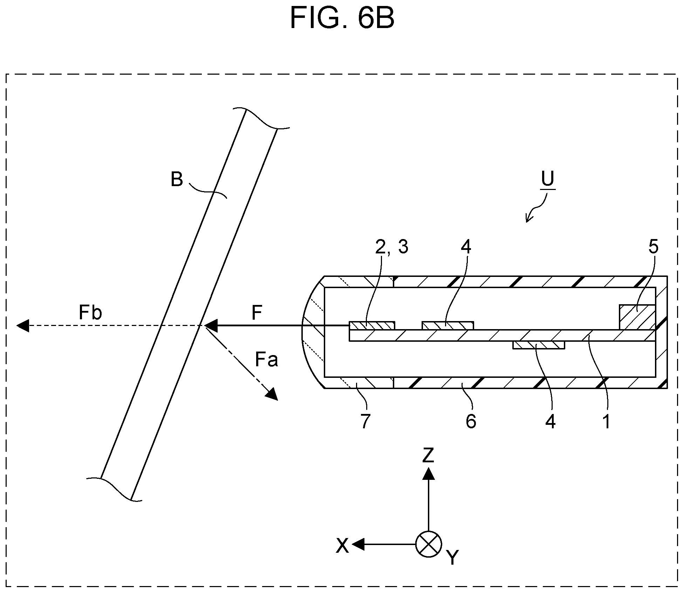

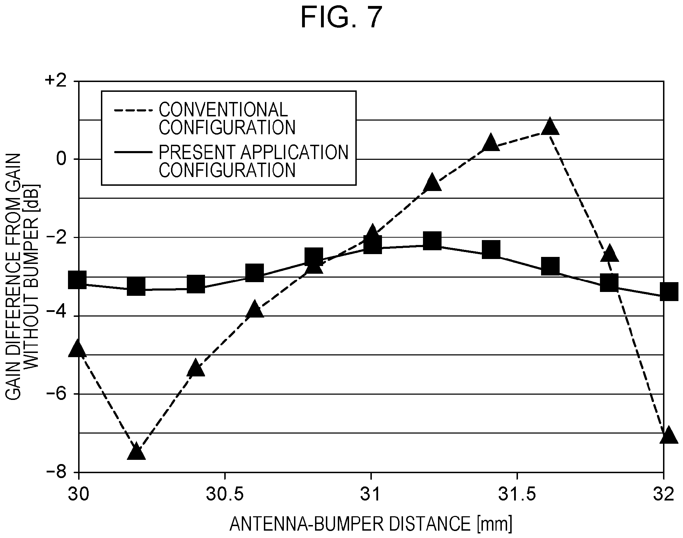

Next, behavior of the electromagnetic wave when the antenna device U according to this embodiment is in operation is described with reference to Figs. 6A, 6B, and 7.

Figs. 6A and 6B are diagrams that illustrate behavior of the electromagnetic wave in the antenna device U according to this embodiment. Fig. 6A illustrates behavior of the electromagnetic wave when the positional relationship between the antenna device U and the cover member B is the same as that in Fig. 4. Fig. 6B illustrates behavior of the electromagnetic wave when the positional relationship between the antenna device U and the cover member B is different from that in Fig. 4 for the purpose of illustration.

The solid arrow F in each of Figs. 6A and 6B represents the electromagnetic wave transmitted by the antenna device U. The dashed-dotted line arrow Fa represents a part of the electromagnetic wave transmitted by the transmitting antenna 2 that is the reflected wave reflected by the cover member B. The dotted line arrow Fb represents rest part of the electromagnetic wave transmitted by the transmitting antenna 2 that is an electromagnetic wave passing through the cover member B.

As described above with reference to Fig. 3, the electromagnetic wave F transmitted from the transmitting antenna 2 is partially reflected by the cover member B and becomes the reflected wave Fa returning back to the antenna device U side.

However, in the antenna device U according to this embodiment, differing from the antenna device 100 according to the conventional technique, the electromagnetic wave is transmitted and received substantially parallel to the board surface of the circuit board 1 using the transmitting antenna 2 and the receiving antenna 3 disposed on the front region of the circuit board 1. Thus, the extending direction of the board surface of the circuit board 1 is disposed so as to intersect with the extending direction of the cover member B. That is, the board surface of the circuit board 1 and the cover member B do not face each other.

Thus, most part of the reflected wave Fa from the cover member B does not enter the housing 6 and is deviated and scattered above and under the housing 6. Also, the reflected wave Fa hitting the housing 6 is not reflected again toward the cover member B side and is deviated and scattered behind the housing 6.

In addition, in the antenna device U according to this embodiment, the transmitting antenna 2 and the receiving antenna 3 on the circuit board 1 respectively transmits and receives the electromagnetic wave through the dielectric lens 7.

Thus, also a part of the reflected wave Fa from the cover member B arriving at the dielectric lens 7 enters a non-flat surface portion of that dielectric lens 7 and is scattered without being collected into the receiving antenna 3. That is, although if the reflected wave Fa arriving at the dielectric lens 7 passes through the dielectric lens 7, the reflected wave Fa arriving from an angle different from a predetermined angle is not collected at the position of the receiving antenna 3, and thus the reflected wave Fa will be scattered inside the housing 6 or dispersed and scattered outside the housing 6. When the reflected wave Fa is reflected by the dielectric lens 7, an angle of the reflection varies by an angle of the surface of the dielectric lens 7 (e.g., when the dielectric lens 7 is a convex lens, the angle of the reflection varies to a direction away from the antenna device); thus, that reflected wave Fa is scattered without causing the multiple reflection.

In this way, in the antenna device U according to this embodiment, the reflected wave Fa from the cover member B is scattered without being multiply reflected between the circuit board 1 and the housing 6. Likewise, in the antenna device U according to this embodiment, the reflected wave Fa from the cover member B diffracts and is thus inhibited from arriving at the position of the receiving antenna 3. Meanwhile, the reflected wave from the object is not disturbed by the above configuration and follows the same route with the transmitted electromagnetic wave to arrive at the position of the receiving antenna 3.

Fig. 7 is a simulation graph of verification of a radar performance of the antenna device U according to this embodiment.

This simulation is calculation of radio field strength (i.e., gain) of the reflected wave from a predetermined target, which is received by the receiving antenna 3, at different distances between the cover member B and the dielectric lens 7 in the antenna device U.

In Fig. 7, a result of the simulation of the antenna device U according to this embodiment (see Fig. 4) is illustrated with a solid line graph while a result of the simulation of the antenna device 100 according to the conventional technique (see Fig. 2) is illustrated with a dotted line graph. Each of the solid line graph and the dotted line graph is plots of the simulation result connected with a line.

In Fig. 7, the vertical axis of the graph indicates the radio field strength of the reflected wave from the predetermined target, which is received by the receiving antenna 3 (here, the radio field strength is indicated by comparing with radio field strength in a case where no cover member B is interposed), while the horizontal axis of the graph indicates a distance between the cover member B and the transmitting antenna 2 (and receiving antenna 3).

As seen from Fig. 7, in the antenna device 100 according to the conventional technique, regions where the radio field strength becomes weaker appear in multiple positions (in Fig. 7, position of 30.25 mm and position of 32.0 mm) depending on the distance between the cover member B and the transmitting antenna 102. This indicates that, in the antenna device 100 according to the conventional technique, a small difference in the distance between the cover member B and the transmitting antenna 102 (or difference in angle) causes the reflected wave Fa from the cover member B to interfere with the reflected wave from the target, and thus there is a region where the detection accuracy is locally deteriorated.

In this regard, the antenna device U according to this embodiment has no region where the radio field strength becomes weaker depending on the distance between the cover member B and the transmitting antenna 2. That is, in the antenna device U according to this embodiment, since the interference of the reflected wave Fa from the cover member B with the reflected wave from the target can be inhibited, the detection accuracy is thus substantially uniform without depending on the positional relationship between the cover member B and the transmitting antenna 2. In particular, this result indicates that, in the antenna device U according to this embodiment, the radar performance for estimating an azimuth of a position of the target is improved.

### [Effect]

As described above, the antenna device U according to this embodiment uses the transmitting antenna 2 and the receiving antenna 3 disposed on the front region of the circuit board 1 to transmit and receive the electromagnetic waves substantially parallel to the board surface of that circuit board 1 and transmits and receives the electromagnetic waves to and from outside the antenna device U through the dielectric lens 7.

This makes it possible to inhibit the multiple reflection of the reflected waves from the cover member B between the cover member B and the antenna device U (e.g., circuit board 1 or housing 6) and arrival of a part of that reflected waves at the receiving antenna 3. Also it is possible to inhibit decrease of output gain due to canceling out of phases by the multiple reflection between the cover (bumper) member and the antenna device U. In this way, for example, it is possible to acquire the gain uniformly in any azimuth in the antenna device U, and thus the accuracy of the azimuth estimation can be improved.

The antenna device U according to this embodiment is particularly useful in terms of acquiring the above effects without depending on the shape of the cover member B.

### (Second Embodiment)

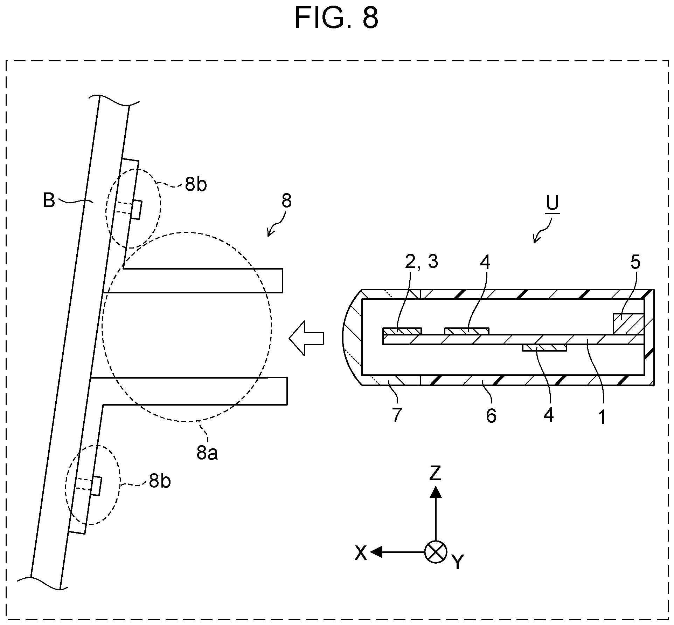

Fig. 8 is a side cross-sectional view that illustrates an example of a configuration of an antenna device U according to a second embodiment.

The antenna device U according to this embodiment is different from the antenna device U according to the first embodiment in that the antenna device U according to this embodiment has a bracket 8 for fixing the housing 6 and the like on the cover member B. Descriptions of configurations common to the first embodiment are omitted (the same applies hereinafter for other embodiments).

The bracket 8 fixes the housing 6 on the cover member B and defines the direction in which the antenna device U transmits and receives the electromagnetic waves.

The bracket 8 has, for example, a storage part 8a that stores the antenna device U and fixing parts 8b that are fixed on the cover member B.

For example, the storage part 8a is in a cylindrical shape that allows the housing 6 to be inserted therein from the front surface (i.e., surface on which the dielectric lens 7 is mounted) and forms a storage space following the outer shape of the housing 6. The storage part 8a has a window in the region of the front surface of the antenna device U on which the dielectric lens 7 is disposed so as to allow the antenna device U to transmit and receive the electromagnetic waves.

The fixing parts 8b are parts that are fixed on the cover member B with a double-sided tape, bolts, and so on. A method of fixing the fixing parts 8b on the cover member B is arbitrary and ultrasonic welding and the like may also be used.

With the above configuration, the bracket 8 fixes the housing 6 on the cover member B such that the direction in which the electromagnetic waves are transmitted and received by the antenna device U is horizontal to the ground, for example. This enables the object detection of the target around the vehicle C.

Material of the bracket 8 is, for example, an electromagnetic wave absorber or material containing the electromagnetic wave absorber. This makes it possible to further inhibit the diffracted wave from entering the window of the housing 6.

The bracket 8 may include an adjustment mechanism (e.g., using pin joint and fixing joint) that can change the angle of the transmission and reception direction of the electromagnetic waves. Using this adjustment mechanism enables fine adjustment of the transmission and reception direction of the electromagnetic waves.

As described above, the antenna device U according to this embodiment can transmit and receive the electromagnetic waves in a desirable direction (e.g., direction horizontal to ground) while remaining mechanical stability.

### (Third Embodiment)

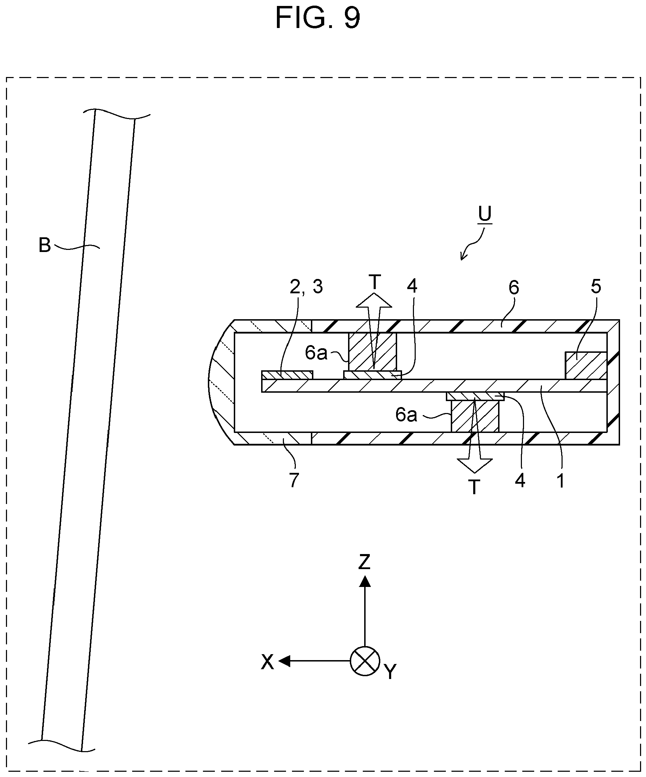

Fig. 9 is a side cross-sectional view that illustrates an example of a configuration of an antenna device U according to a third embodiment.

The antenna device U according to this embodiment is different from the antenna device U according to the first embodiment in that the housing 6 has connection units 6a that thermally bond with the circuit board 1 or circuit parts mounted on that circuit board 1.

Fig. 9 illustrates a state where the connection units 6a thermally bond the walls of the housing 6 and the signal processing ICs 4. White arrows T in Fig. 9 represent heat flows from the circuit board 1.

In this embodiment, a metal member with high heat release characteristics is used as the material of the housing 6, for example. The connection units 6a thus thermally bond the walls of the housing 6 and the circuit board 1 or the circuit parts mounted on that circuit board 1.

The configuration of the connection units 6a is arbitrary; the connection units 6a may be integrally formed with the walls of the housing 6 or may be made of silicon grease or bond material such as epoxy resin. Otherwise the connection units 6a may be members in a form of putty, rubber, gel, or a compound.

Since the antenna device U according to the present disclosure allows the entire region of the housing 6 except the front surface to be a wall region that can release heat, the antenna device U according to the present disclosure can acquire a wider wall region of the housing 6 that can release heat than that of the antenna device 100 according to the conventional technique (see Fig. 2). Thus, the configuration for releasing heat from the housing 6 using the connection units 6a is particularly effective for improving the characteristics of heat release from the circuit board 1 in the antenna device U according to the present disclosure.

As described above, the antenna device U according to this embodiment can improve the heat release characteristics of the circuit board 1 and the like.

### (Fourth Embodiment)

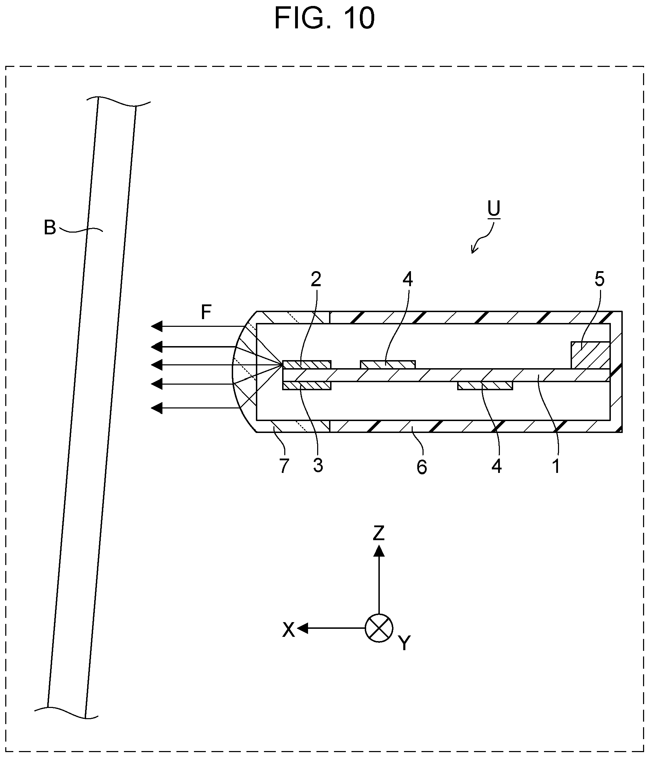

Fig. 10 is a side cross-sectional view of the antenna device U according to the fourth embodiment.

The antenna device U according to this embodiment is different from the antenna device U according to the first embodiment in that the transmitting antenna 2 and/or the receiving antenna 3 are disposed on both the board surface on the front surface side and the board surface on the back surface side of the circuit board 1.

Fig. 10 illustrates an aspect where the transmitting antenna 2 is disposed on the front surface side of the circuit board 1 while the receiving antenna 3 is disposed on the back surface side of the circuit board 1.

Instead of the aspect where both the transmitting antenna 2 and the receiving antenna 3 are disposed together on either one of the front surface side and the back surface side of the circuit board 1, the transmitting antenna 2 and the receiving antenna 3 may be disposed individually on both the front surface side and the back surface side of the circuit board 1.

In the antenna device U according to this embodiment, making both the board surface of the front surface side and the board surface of the back surface side of the circuit board 1 as the antenna disposing regions makes it possible to dispose more numbers of antenna elements on the surface of the circuit board 1.

As described above, the antenna device U according to this embodiment can further increase the gain.

### (Fifth Embodiment)

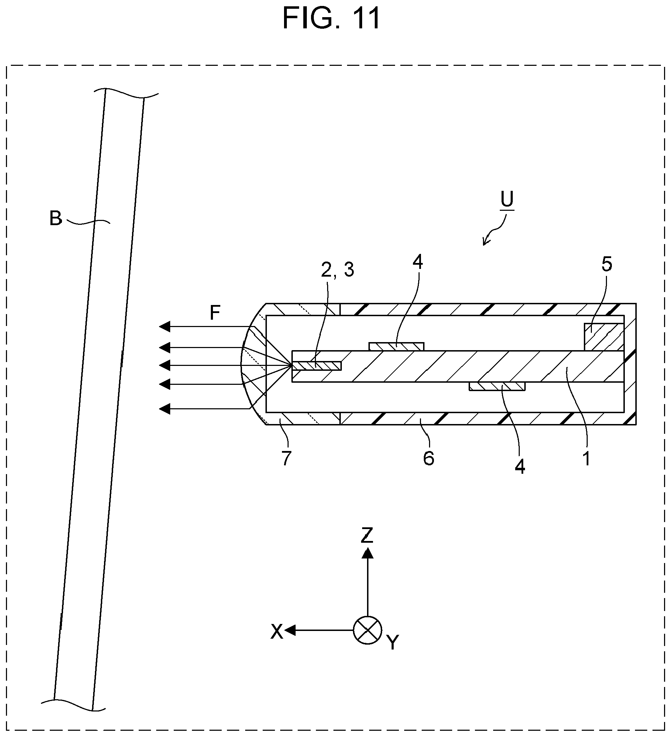

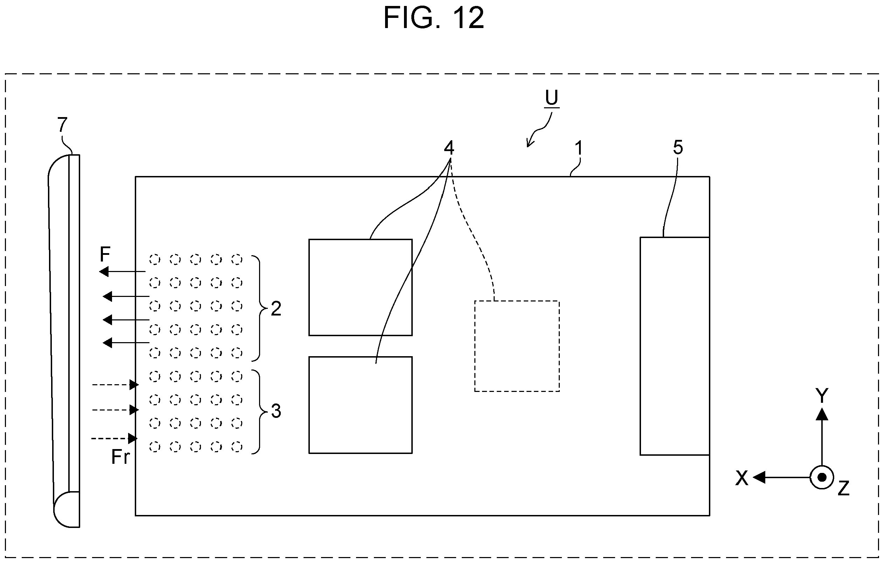

Figs. 11 and 12 are diagrams that illustrate an example of a configuration of an antenna device U according to a fifth embodiment. Fig. 11 illustrates a side cross-sectional view of the antenna device U while Fig. 12 illustrates a plane view of the antenna device U.

The antenna device U according to this embodiment is different from the antenna device U according to the first embodiment in that each of the transmitting antenna 2 and the receiving antenna 3 is composed of the post-wall waveguide antenna.

The post-wall waveguide antenna includes arranged bodies of metal posts (illustrated with dotted lines in Fig. 12) vertically extending inside the circuit board 1 (here, dielectric board). Once driving signals are supplied to the corresponding metal posts, the post-wall waveguide antenna transmits the electromagnetic waves in the direction in which the metal posts are arranged.

Likewise the first embodiment, the transmitting antenna 2 and the receiving antenna 3 according to this embodiment are also disposed on the front region of the circuit board 1 and respectively transmits and receives the electromagnetic waves on the front end side of the circuit board 1.

As described above, the antenna device U according to this embodiment also can reduce the effects of the reflected wave Fa from the cover member B. The antenna device U according to this embodiment is more preferable than the antenna device U according to the first embodiment in terms of inhibiting the entry of the reflected wave Fa from the cover member B.

### (Sixth Embodiment)

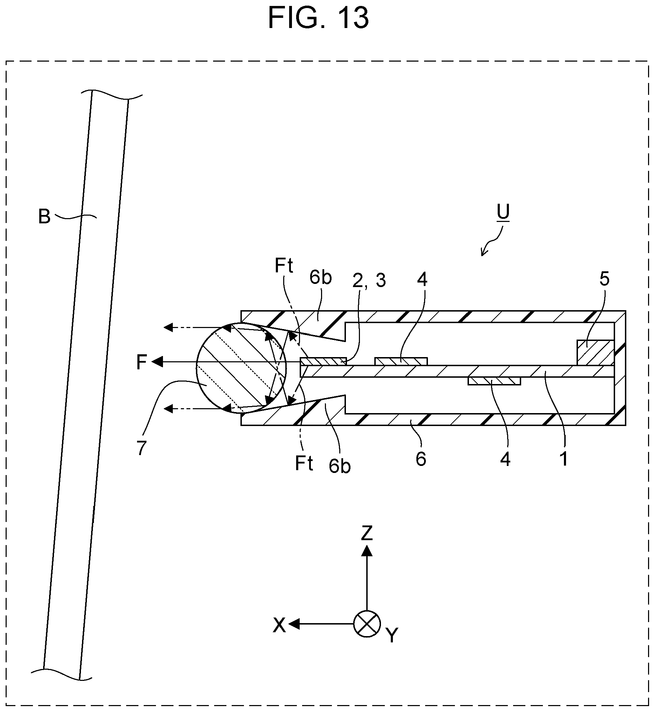

Fig. 13 is a side cross-sectional view that illustrates an example of a configuration of an antenna device U according to a sixth embodiment.

The antenna device U according to this embodiment is different from the antenna device U according to the first embodiment in that the antenna device U according to this embodiment has reflection units 6b that are supported at positions facing the board surface of the circuit board 1 and reflect sidelobes of the electromagnetic waves, which are transmitted from the transmitting antenna 2, in the front direction, and in that the dielectric lens 7 is composed of a ball lens.

On inner walls forming the storage space of the housing 6, the reflection units 6b are respectively formed above and below the front region of the circuit board 1 to reflect the sidelobes of the electromagnetic waves transmitted by the transmitting antenna 2 (illustrated with dashed-double dotted line arrows Ft in Fig. 13) and convert the traveling direction of the reflected waves to the front direction.

On the inner walls of the housing 6, the reflection units 6b are disposed so as to cover upper and lower sides of the transmitting antenna 2 and are formed to be inclined such that a front part of a reflection surface is farther from the transmitting antenna 2 than a rear part thereof. Fig. 13 illustrates an aspect where the reflection units 6b are, for example, made of metal material integrally with other parts of the housing 6.

The dielectric lens 7 according to this embodiment is composed of the ball lens. The ball lens has lens characteristics of a short focal distance. Thus, the ball lens can convert the traveling direction of the electromagnetic waves that are reflected from the reflection units 6b and inclined forward, like the dashed-double dotted line arrows Ft in Fig. 13, to the front direction. When the sidelobes Ft of the electromagnetic waves are reflected from outside the antenna device U and return back, the sidelobes Ft of the electromagnetic waves pass through the dielectric lens 7 and the reflection units 6b again and enter the receiving antenna 3.

The reflection units 6b and the dielectric lens 7 are, for example, designed to allow the sidelobes Ft to be plane waves traveling in the front direction with a phase same as that of a mainlobe F when the sidelobes Ft are transmitted outside the antenna device U.

As described above, regarding the electromagnetic waves transmitted by the transmitting antenna 2, the antenna device U according to this embodiment can utilize also the sidelobes Ft as radar signals. This can further increase the gain.

### (Seventh Embodiment)

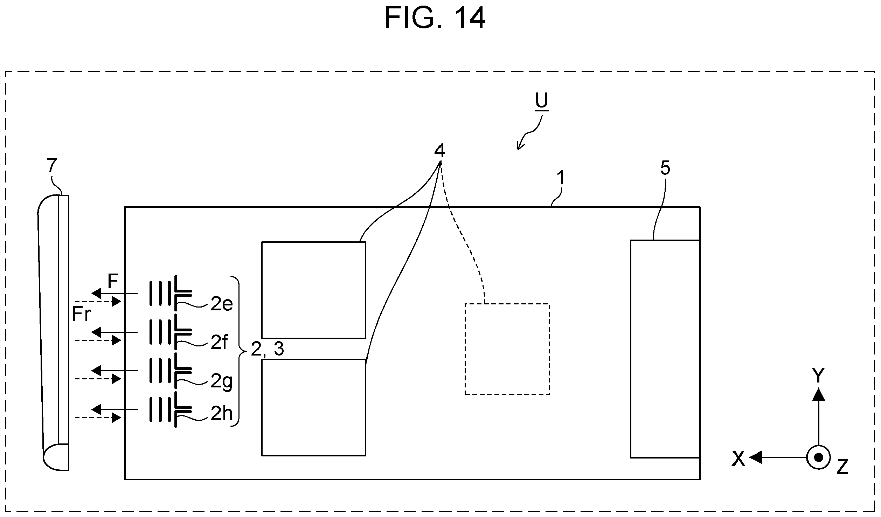

Fig. 14 is a plan view that illustrates an example of an antenna device U according to a seventh embodiment.

The antenna device U according to this embodiment is different from the antenna device U according to the first embodiment in that the transmitting antenna 2 and the receiving antenna 3 are composed of a common antenna (here, four antenna elements 2e, 2f, 2g, and 2h).

In other words, the antenna device U according to this embodiment is controlled by the signal processing ICs 4 to execute the transmission operation of the electromagnetic waves and the reception operation of the electromagnetic waves in time-sharing on the antenna elements 2e, 2f, 2g, and 2h. Transfers of the electric signals between the antenna elements 2e, 2f, 2g, and 2h and the transmission circuit (signal processing IC 4 for transmission) and transfers of the electric signals between the antenna elements 2e, 2f, 2g, and 2h and the reception circuit (signal processing IC 4 for reception) are, for example, switched in time-sharing by a switch or circulator.

As described above, the antenna device U according to this embodiment can reduce the number of the antenna elements arranged in the Y direction. In this way, in the Y direction, since the size of the window of the housing 6 can be minimized, it is possible to further inhibit the reflected wave from the cover member B from entering the housing 6.

### (Eighth Embodiment)

In the above embodiments, a radar device is used for describing an example of an application target of the antenna device U; however, the antenna device U according to the present disclosure can also be applied to communication use.

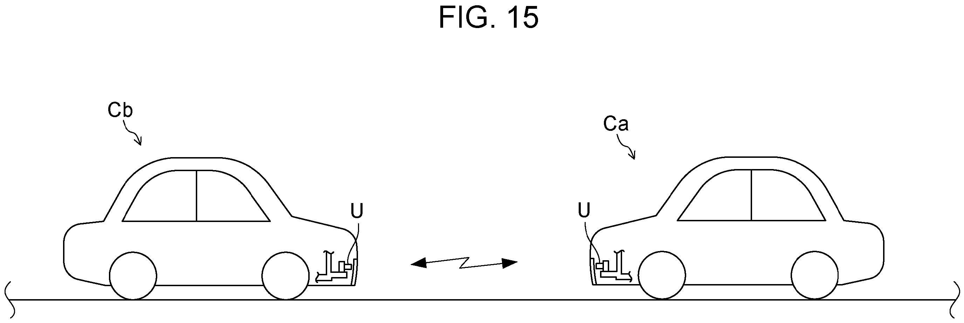

Fig. 15 is a diagram that illustrates an example of an antenna device U according to an eighth embodiment.

Fig. 15 illustrates a situation where the antenna device U mounted in one vehicle Ca and the antenna device U mounted in the other vehicle Cb transmit and receive the electromagnetic waves therebetween and communicate to each other (i.e., vehicle-to-vehicle communications). The antenna device U according to this embodiment may be mounted with signal processing ICs for communications (not illustrated) instead of the above-described signal processing ICs 4 for object detection.

Since the antenna device U according to the present disclosure can inhibit decrease of the output gain due to canceling out of phases by the multiple reflection between the cover (bumper) member and the antenna device U even when transmitting the electromagnetic waves through the cover member B, it is possible to preferably use the antenna device U according to the present disclosure for an aspect of communicating with another antenna device like this embodiment.

### (Other Embodiments)

The present disclosure is not limited to the above-described embodiments and various modifications can be considered. For example, it is needless to say that various combinations of the aspects described in those embodiments may be used.

In the above-described embodiments, the aspect where the extending direction of the board surface of the circuit board 1 and the extending direction of the cover member B are substantially orthogonal to each other is described as an example of the positional relationship between the circuit board 1 and the cover member B. However, the present disclosure can be applied to an aspect where the extending direction of the board surface of the circuit board 1 and the extending direction of the cover member B intersect at an arbitrary angle.

In the above-described embodiments, the aspect where the angle of transmission of the electromagnetic waves from the transmitting antenna 2 (and the angle of reception of the reflected waves from the receiving antenna 3) is parallel to the board surface of the circuit board 1 is described as an example. However, the angle of transmission of the electromagnetic waves from the transmitting antenna 2 may be inclined to an upper or lower side of the board surface of the circuit board 1 as long as that is in the direction of the front end side of the circuit board 1. In other words, the direction of transmitting and receiving the electromagnetic waves to and from the transmitting antenna 2 and the receiving antenna 3 may be at least substantially parallel to the board surface of the circuit board 1.

In the above-described embodiments, the aspect of having the dielectric lens 7 is described as an example of the antenna device U. However, if there are no problems of gain of transmission and reception of the electromagnetic waves and shielding of the reflected wave arriving at the receiving antenna 3 from the cover member B, an aspect of having no dielectric lens 7 may be available.

In the above-described embodiments, the aspect where the antenna device U is covered by the cover member B is described as an example of an aspect where the antenna device U is preferably applied. However, it is needless to say that the antenna device U according to the present disclosure can also be applied to an aspect where the front region is not covered by the cover member B.

Although specific examples of the present disclosure are described in detail, these are merely examples and do not intend to limit the scope of claims. The techniques described in the scope of claims include various modifications and changes of the specific examples described above.

According to the antenna device of the present disclosure, it is possible to perform object detection with high accuracy even when transmitting and receiving electromagnetic waves through a cover member.

The present disclosure can be realized by software, hardware, or software in cooperation with hardware.

Each functional block used in the description of each embodiment described above can be partly or entirely realized by an LSI such as an integrated circuit, and each process described in each embodiment may be controlled partly or entirely by the same LSI or a combination of LSIs. The LSI may be individually formed as chips, or one chip may be formed so as to include a part or all of the functional blocks. The LSI may include a data input and output coupled thereto. The LSI here may be referred to as an IC, a system LSI, a super LSI, or an ultra LSI depending on a difference in the degree of integration.

However, the technique of implementing an integrated circuit is not limited to the LSI and may be realized by using a dedicated circuit, a general-purpose processor, or a special-purpose processor. In addition, a FPGA (Field Programmable Gate Array) that can be programmed after the manufacture of the LSI or a reconfigurable processor in which the connections and the settings of circuit cells disposed inside the LSI can be reconfigured may be used. The present disclosure can be realized as digital processing or analogue processing.

If future integrated circuit technology replaces LSIs as a result of the advancement of semiconductor technology or other derivative technology, the functional blocks could be integrated using the future integrated circuit technology. Biotechnology can also be applied.

## Claims

1. An antenna device that includes a housing formed with an window surface and transmits and receives an electromagnetic wave through a cover member facing the window surface, comprising:
a transmitting antenna that is provided inside the housing and transmits the electromagnetic wave to a side of the cover member;
a receiving antenna that receives the electromagnetic wave;
a circuit board that extends along a transmission direction of the electromagnetic wave and includes a board surface provided with the transmitting antenna and the receiving antenna; and
a dielectric lens covering the window surface that narrows a beam of the electromagnetic wave transmitted from the transmitting antenna to transmit the beam outside the housing and collects the electromagnetic wave from outside the housing to transmit the electromagnetic wave to the receiving antenna.

2. The antenna device according to Claim 1, wherein
the transmitting antenna and the receiving antenna are each composed of a conductor pattern formed on the circuit board.

3. The antenna device according to Claim 2, wherein
the transmitting antenna and the receiving antenna are end-fire array antennae disposed on a front region in the board surface of the circuit board.

4. The antenna device according to Claim 3, wherein
any of an antenna element of the transmitting antenna and an antenna element of the receiving antenna is disposed on any of two board surfaces of a front surface side and a back surface side of the circuit board.

5. The antenna device according to Claim 2, wherein
the transmitting antenna and the receiving antenna are post-wall waveguide antennae that are disposed so as to have apertures toward a front end side of the circuit board.

6. The antenna device according to Claim 1, wherein
the dielectric lens converts the electromagnetic wave transmitted from the transmitting antenna to a plane wave and transmits the plane wave outside the device.

7. The antenna device according to Claim 1, wherein
the dielectric lens is composed of a convex lens that has a convex shape in a front surface side.

8. The antenna device according to Claim 1, further comprising:
a signal processing unit that estimates an azimuth of a target based on a reflected wave from the target that is a part of the electromagnetic wave transmitted from the transmitting antenna.

9. The antenna device according to Claim 1, wherein
the housing includes metal material.

10. The antenna device according to Claim 1, wherein
the housing is made of a material with higher thermal conductivity than the dielectric lens.

11. The antenna device according to Claim 1, wherein
when a normal direction of the board surface of the circuit board is regarded as a vertical direction, a length in the vertical direction of the housing is shorter than a length in a front-rear direction of the housing.

12. The antenna device according to Claim 1, wherein
the housing includes a connection unit that thermally bonds with the circuit board or a circuit part mounted on the circuit board.

13. The antenna device according to Claim 1, further comprising:
a bracket that fixes the housing on the cover member arranged to cover a front region outside the device and defines a direction in which the electromagnetic wave is transmitted outside the device.

14. The antenna device according to Claim 13, wherein
the bracket fixes the housing on the cover member so as to make the direction in which the electromagnetic wave is transmitted outside the device horizontal to a ground.

15. The antenna device according to Claim 13, wherein
the bracket is made of an electromagnetic wave absorber or material containing the electromagnetic wave absorber.

16. The antenna device according to Claim 1, further comprising:
a reflection unit that is supported at a position facing the board surface of the circuit board to reflect a sidelobe of the electromagnetic wave transmitted by the transmitting antenna to a front direction.

17. The antenna device according to Claim 16, wherein
the dielectric lens is composed of a ball lens.

18. The antenna device according to Claim 1 mounted in a vehicle.
